# EUROPEAN PATENT APPLICATION

(11) **EP 4 174 077 A1**
(43) Date of publication of application: **03.05.2023**
(21) Application number: 21205081.9
(22) Date of filing: 27.10.2021
(51) Int. Cl.: C07F 9/38, C09K 19/12, H01L 27/24

(54) **ELECTRONIC SWITCHING DEVICE**

(71) Applicant: Merck Patent GmbH, 64293 Darmstadt (DE); Technische Universität München, 80333 München (DE)
(72) Inventor: Kirsch, Peer, 64293 Darmstadt (DE); Seim, Henning, 64293 Darmstadt (DE); Voges, Frank, 64293 Darmstadt (DE); Tornow, Marc, 80333 München (DE); Dlugosch, Julian, 80333 München (DE)

(57) **Abstract**

The present invention relates to an electronic switching device, in particular to tunnel junctions, comprising an organic molecular layer for use in memory, sensors, field-effect transistors or Josephson junctions. More particularly, the invention is included in the field of random access non-volatile memristive memories (RRAM). Another aspect of the invention relates to a compound of formula I 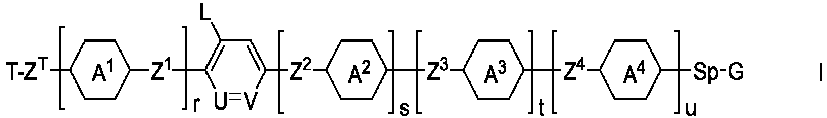 in which the occurring groups habe the meanings defined in claim 1, for use in the molecular layer. The invention further relates to the use of said molecular layer and to processes for the production and operation of the electronic switching element and components based thereon.

## Description

The present invention relates to an electronic switching device, in particular to tunnel junctions, comprising an organic molecular layer for use in memory, sensors, field-effect transistors or Josephson junctions. More particularly, the invention is included in the field of random access non-volatile memristive memories (RRAM). Further aspects of the invention relate to compounds for use in the molecular layer, to the use of the molecular layer and to processes for the production and operation of the electronic switching element and components based thereon.

Tunnel junctions are used for many applications in electronics industry, ranging from superconducting Josephson junctions to tunnel diodes. They require a very thin dielectric material as insulator. One of the most cost-effective ways to generate such an insulating layer with single digit nanometer thickness is by using self-assembled monolayers (SAMs).

In computer technology, storage media are required which allow rapid writing and reading access to information stored therein. Solid-state memories or semiconductor memories allow particularly fast and reliable storage media to be achieved, since absolutely no moving parts are necessary. At present, use is mainly made of dynamic random access memory (DRAM). DRAM allows rapid access to the stored information, but this information has to be refreshed regularly, meaning that the stored information is lost when the power supply is switched off.

The prior art also discloses non-volatile semiconductor memories, such as flash memory or magnetoresistive random access memory (MRAM), in which the information is retained even after the power supply has been switched off. A disadvantage of flash memory is that writing access takes place comparatively slowly and the memory cells of the flash memory cannot be erased ad infinitum. The lifetime of flash memory is typically limited to a maximum of one million read/write cycles. MRAM can be used in a similar way to DRAM and has a long lifetime, but this type of memory has not been able to establish itself owing to the difficult production process.

A further alternative is memory which works on the basis of memristors. The term memristor is a contraction of the words "memory" and "resistor" and denotes a component which is able to change its electrical resistance reproducibly between a high and a low electrical resistance. The respective state (high resistance or low resistance) is retained even without a supply voltage, meaning that non-volatile memories can be achieved with memristors. Crossbar arrays of memristors may be used in a variety of applications, including non-volatile solid state memory, programmable logic, signal processing, control systems, pattern recognition, and other applications. A memristive cross-bar array includes a number of row lines, a number of column lines intersecting the row lines to form a number of junctions, and a number of resistive memory devices coupled between the row lines and the column lines at the junctions.

WO 2012/127542 A1 and US 2014/008601 A1, for example, disclose organic molecular memories which have two electrodes and an active region which is arranged between the two electrodes. The active region has a molecular layer of electrically conductive aromatic alkynes, whose conductivity can be changed under the influence of an electric field. Similar components based on redox-active bipyridinium compounds are proposed in US 2005/0099209 A1.

The known memories based on a change in conductivity or resistance have the disadvantage that the free-radical intermediates formed by the flow of current through the molecules of the molecular layer are in principle susceptible to degradation processes, which has an adverse effect on the lifetime of the components.

In WO 2018/007337 A2 an improved switching layer is described that makes use of a non-redox active molecular layer comprising dipolar compounds linked to a substrate via an aliphatic spacer group where the compounds are reversibly switched by application of an electric field which causes re-orientation of the molecular dipole and thus enabling a low-resistive state and a high-resistive state depending on the respective orientation of the molecules.

In order to obtain electrically switchable tunnel junctions from organic compounds with a conformationally flexible dipole, a molecular layer enclosed as a sandwich between two conductive electrodes is required. The deposition of this molecular layer onto electrodes is achieved either by spin-coating or by dip-coating from an organic solvent. The basic principle of the resulting memory device is described in WO 2016/110301 A1 and WO 2018/007337 A2.

Information storage devices based on electrically switchable tunnel barriers made from self-assembled, dipolar monolayers are required to have long retention times of the selected states, even at elevated temperatures of for example up to 85°C. A long retention time enables a memory device that requires less refresh cycles. There is still a need in the art for devices with long retention times.

It is an object of the present invention to provide new compounds for the fabrication of improved electronic components comprising a molecular layer bonded to a first electrode, suitable for use in for example memristive devices, which do not have the above mentioned disadvantages and which bring improvements, in particular, with respect to improved retention times.

To solve the problem there is provided a compound of formula I 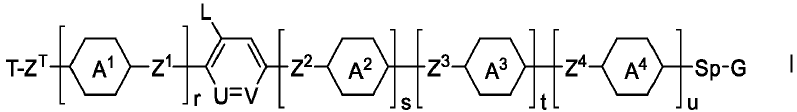 in which
U and V, identically or differently, denote C-F, C-CI, C-CF₃, C-CN or N,
L denotes straight chain or branched or cyclic alkyl or alkenyl each having 1 to 8 C atoms, where one or more non-adjacent CH₂ groups in these radicals may each be replaced, independently of one another, by -O- or -S-, and in which one or more H atoms may be replaced by F,
T is selected from the group of radicals consisting of the following groups:
   a) straight chain or branched alkyl or alkoxy each having 1 to 20 C atoms, where one or more CH₂ groups in these radicals may each be replaced, independently of one another, by -C≡C- , -CH=CH-, 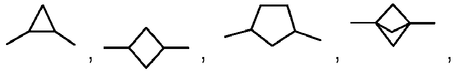 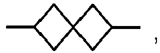 -O-, -S-, -CF₂O-, -OCF₂-, -CO-O-, -O-CO- ,-SiR⁰R⁰⁰- , -NH- , -NR⁰- or -SO₂- in such a way that O atoms are not linked directly to one another, and in which one or more H atoms may be replaced by halogen, CN, SCN or SF₅, wherein R⁰, R⁰⁰, identically or differently, denote an alkyl or alkoxy radical having 1 to 15 C atoms, in which, in addition, one or more H atoms may be replaced by halogen,
   b) a three- to ten-membered saturated or partially unsaturated aliphatic ring, in which at least one -CH₂- group is replaced with -O-, -S-, -S(O)-, -SO₂-, -NR^{x}- or -N(O)R^{x}-, or in which at least one -CH= group is replaced with -N=, where R^{x} denotes straight-chain or branched alkyl having 1 to 6 C atoms,
   c) a diamondoid radical, preferably derived from a lower diamondoid, very preferably selected from the group consisting of adamantyl, diamantyl, and triamantyl, in which one or more H atoms can be replaced by F, in each case optionally fluorinated alkyl, alkenyl or alkoxy having up to 12 C atoms, in particular 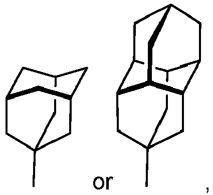
      - Z^{T}, Z¹, Z², and Z⁴,: on each occurrence, identically or differently, denote a single bond, -CF₂O-, -OCF₂-, -CF₂S-, -SCF₂-, -CH₂O-, -OCH₂-, -C(O)O-, -OC(O)-, -C(O)S-, -SC(O)-, -(CH₂)ₙ₁-, -(CF₂)ₙ₂-, -CF₂ CH₂-, -CH₂CF₂-, -CH=CH-,-CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- or -N=C-C=N-, wherein n1, n2, n3, n4, identically or differently, are 1, 2, 3, 4, 5, 6, 7, 8, 9 or 10,
      - Z³: denotes -O-, -S-, -CH₂-, -C(O)-, -CF₂-, -CHF-, -C(R^{x})₂-, -S(O)- or -SO₂-, 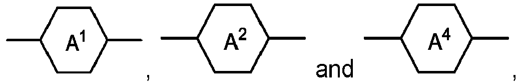 on each occurrence, identically or differently, denote an aromatic, heteroaromatic, alicyclic or heteroaliphatic ring having 4 to 25 ring atoms, which may also contain condensed rings and which may be mono- or polysubstituted by Y, 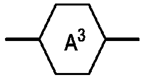 denotes an aromatic or heteroaromatic ring having 5 to 25 ring atoms, which may also contain condensed rings and which may be mono- or polysubstituted by Y^{C},
      - Y: on each occurrence, identically or differently, denotes F, Cl, CN, SCN, SF₅ or straight-chain or branched, in each case optionally fluorinated alkyl, alkoxy, alkylcarbonyl, alkoxycarbonyl, alkylcarbonyloxy or alkoxycarbonyloxy having 1 to 12 C atoms, preferably F or Cl,
      - Y^{C}: has one of the meanings of Y or denotes cycloalkyl or alkylcycloalkyl each having 3 to 12 C atoms, preferably methyl, ethyl, isopropyl, cyclopropyl, cyclobutyl, cyclopentyl, cyclohexyl, trifluoromethyl, methoxy or trifluoromethoxy,
      - Sp: denotes a spacer group or a single bond,
      - R⁰, R⁰⁰, R^{x}: denotes straight-chain or branched alkyl having 1 to 6 C atoms,
      - G: denotes -OH, -SH, -SO₂OH, -OP(O)(OH)₂, -PO(OH)₂, -C(OH)(PO(OH)₂)₂, -COOH, -Si(OR^{x})₃, -SiCl₃, -CH=CH₂, -POCl₂, -COH(PO(OH)₂)₂, -CO(NHOH), -CO(NR⁰OH), -Si(NMe₂)₃; or straight chain or branched alkyl having 1 to 12 C atoms in which one, two or three not geminal H atoms are substituted by OH; or a group selected from -O-C(O)-OR^{V}, -O-C(O)-Si(OR^{x})₃, PO(OR^{V})₂, SO₂OR^{V},
      - R^{V}: denotes straight chain or branched alkyl having 1 to 12 C atoms, and
      - r, s, t and u,: identically or differently, are 0, 1 or 2.

According to another aspect of the present invention there is provided a switching device comprising, in this sequence,
a first electrode,
a molecular layer bonded to the first electrode, and
a second electrode,
where the molecular layer is essentially formed from one or more, preferably one, compounds of the formula I defined above and below.

The invention furthermore relates to a process for the production of the switching device according to the invention comprising at least the following steps:
i. production of a first electrode having a surface;
ii. deposition of a molecular layer comprising one or more compounds selected from the group of compounds of the formula I defined above onto the surface of the first electrode;
iii. application of a second electrode.

The invention furthermore relates to a method for operating the electronic component according to the invention, characterised in that a switching device of the electronic component is switched into a state of high electrical resistance by setting a corresponding first electrode to a first electrical potential and setting a corresponding second electrode to a second electrical potential, where the value of the voltage between the two electrodes is greater than a first switching voltage and the first potential is greater than the second potential, a switching device of the electronic component is switched into a state of low electrical resistance by setting a corresponding first electrode to a third electrical potential and setting a corresponding second electrode to a fourth electrical potential, where the value of the voltage between the two electrodes is greater than a second switching voltage and the fourth potential is greater than the third potential, and the state of a switching device is determined by applying a reading voltage whose value is smaller than the first and second switching voltages between corresponding electrodes and measuring the current flowing.

According to another aspect of the present invention there is provided an electronic component where the component is a memristive crossbar array comprising a multitude of switching devices according to the present invention. Said crossbar array can be integrated into a three dimensional array of cells comprising a stack of two or more crossbar arrays. Such configurations are known as 3D cross-point or 3D X-point memory devices.

The invention further relates to the use of a molecular layer obtained from one or more compounds as indicated in claim 1 in a memristive electronic component.

The resulting devices can be used in memory, sensors, field-effect transistors or Josephson junctions, preferably in resistive memory devices.

The present invention further relates to the use of the switching devices in memory, sensors, field-effect transistors or Josephson junctions.

The switching devices according to the invention are suitable for use in electronic components, in particular in memory, sensors, field-effect transistors or Josephson junctions, very particularly in memristive components such as memristive crossbar-arrays, which exhibit the advantageous properties indicated above.

The compound of formula I according to the invention enables a switching device that is distinguished by retention improved by several orders of magnitude compared to the state of the art. Tunnel junctions based on the SAM precursors of formula I above show a significantly higher current density in their current-voltage characteristics, allowing for a faster read operation and higher integration density.

The switching voltage of the switching device according to the invention is advantageously low. The switching device exhibits high reliability and endurance. Furthermore, the memory window is advantageously large and improved over the devices known from prior art.

The electrode materials that can be used in the device according to the invention are highly compatible with devices and fabrication processes of the semiconductor industry and are surprisingly well suitable for the formation of a stable and homogeneous molecular monolayer.

### Brief description of the drawings.

Fig. 1A shows a schematic illustration of the layer structure of a first embodiment of the electronic switching device.
Fig. 1B shows a schematic illustration of the layer structure of a second embodiment of the electronic switching device according to the invention.
Fig. 2 shows a current-voltage curve of an electronic switching device according to the invention in comparison with a similar device fabricated using a compound of the sate of the art.
Fig. 3 shows the decay of the HRS and LRS of an electronic switching device according to the invention in comparison with a similar device fabricated using a compound of the sate of the art.

In claim 8, the expression "essentially formed from" is taken to mean that specific further compounds can be present in the compounds that are used for the formation of the molecular layer, namely those not materially affecting the essential characteristics of the molecular layer.

As used herein, the term "RRAM" or "resistive memory device" is taken to mean a memory device that uses a molecular switching layer whose resistance can be can be controlled by applying a voltage.

Low resistance state (LRS) or ON state of the resistive memory device is taken to mean a state in which the resistive memory device has a low electrical resistance. High resistance state (HRS) or OFF state of the resistive memory device is taken to mean a state in which the resistive memory device has a high resistance.

Memory window is taken to mean an interval of resistance values having a lower bound and an upper bound.

States having a resistance lower than the lower bound of this interval are considered as ON states.

States having a resistance higher than the upper bound of this interval are considered as OFF states.

The term "diamondoids" refers to substituted and unsubstituted cage compounds of the adamantane series including adamantane, diamantane, triamantane, tetramantanes, pentamantanes, hexamantanes, heptamantanes, octamantanes, and the like, including all isomers and stereoisomers thereof. The compounds have a "diamondoid" topology, which means their carbon atom arrangement is superimposable on a fragment of a face centered cubic diamond lattice. Substituted diamondoids from the first of the series are preferable with 1 to 4 independently-selected alkyl or alkoxy substituents. Diamondoids include "lower diamondoids" and "higher diamondoids," as these terms are defined herein, as well as mixtures of any combination of lower and higher diamondoids. The term "lower diamondoids" refers to adamantane, diamantane and triamantane and any and/or all unsubstituted and substituted derivatives of adamantane, diamantane and triamantane. These lower diamondoid components show no isomers or chirality and are readily synthesized, distinguishing them from "higher diamondoids." The term "higher diamondoids" refers to any and/or all substituted and unsubstituted tetramantane components; to any and/or all substituted and unsubstituted pentamantane components; to any and/or all substituted and unsubstituted hexamantane components; to any and/or all substituted and unsubstituted heptamantane components; to any and/or all substituted and unsubstituted octamantane components; as well as mixtures of the above and isomers and stereoisomers of tetramantane, pentamantane, hexamantane, heptamantane, and octamantane. Adamantane chemistry has been reviewed by Fort, Jr. et al. in "Adamantane: Consequences of the Diamondoid Structure," Chem. Rev. vol. 64, pp. 277-300 (1964). Adamantane is the smallest member of the diamondoid series and may be thought of as a single cage crystalline subunit. Diamantane contains two subunits, triamantane three, tetramantane four, and so on. While there is only one isomeric form of adamantane, diamantane, and triamantane, there are four different isomers of tetramantane, (two of which represent an enantiomeric pair), i.e., four different possible ways or arranging the four adamantane subunits. The number of possible isomers increases non-linearly with each higher member of the diamondoid series, pentamantane, hexamantane, heptamantane, octamantane, etc. Adamantane, which is commercially available, has been studied extensively. The studies have been directed toward a number of areas, such as thermodynamic stability, functionalization, and the properties of adamantane-containing materials. For instance, Schreiber et al., New J. Chem., 2014, 38, 28-41 describes the synthesis and application of functionalized diamondoids to form large area SAMs on silver and gold surfaces. In K. T. Narasimha et al., Nature Nanotechnology 11, March 2016 page 267-273, monolayers of diamondoids are described to effectively confer enhanced field emission properties to metal surfaces due to a significant reduction of the work function of the metal.

As used herein, an anchor group is a functional group by means of which a compound is adsorbed onto or bonded to the surface of the substrate or electrode by physisorption, chemisorption or by chemical reaction. This chemical reaction includes the transformation of a precursor of an anchor group *in situ,* for example on the surface of a substrate or electrode.

A spacer group in the sense of the present invention is a flexible chain between dipolar moiety and anchor group which causes a separation between these sub-structures and, owing to its flexibility, at the same time improves the mobility of the dipolar moiety after bonding to a substrate.

The spacer group can be branched or straight chain. Chiral spacers are branched and optically active and non racemic.

Herein, alkyl is straight-chain or branched and has 1 to 15 C atoms, is preferably straight-chain and has, unless indicated otherwise, 1, 2, 3, 4, 5, 6 or 7 C atoms and is accordingly preferably methyl, ethyl, propyl, butyl, pentyl, hexyl or heptyl.

Herein, an alkoxy radical is straight-chain or branched and contains 1 to 15 C atoms. It is preferably straight-chain and has, unless indicated otherwise, 1, 2, 3, 4, 5, 6 or 7 C atoms and is accordingly preferably methoxy, ethoxy, propoxy, butoxy, pentoxy, hexoxy or heptoxy.

Herein, an alkenyl radical is preferably an alkenyl radical having 2 to 15 C atoms, which is straight-chain or branched and contains at least one C-C double bond. It is preferably straight-chain and has 2 to 7 C atoms. Accordingly, it is preferably vinyl, prop-1- or -2-enyl, but-1-, -2- or -3-enyl, pent-1-, -2-, -3- or -4-enyl, hex-1-, -2-, -3-, -4- or -5-enyl, hept-1-, -2-, -3-, -4-, -5- or -6-enyl. If the two C atoms of the C-C double bond are substituted, the alkenyl radical can be in the form of E and/or Z isomer (trans/cis). In general, the respective E isomers are preferred. Of the alkenyl radicals, prop-2-enyl, but-2- and -3-enyl, and pent-3- and -4-enyl are particularly preferred.

Herein alkynyl is taken to mean an alkynyl radical having 2 to 15 C atoms, which is straight-chain or branched and contains at least one C-C triple bond. 1- and 2-propynyl and 1-, 2- and 3-butynyl are preferred.

The compounds of the general formula I are prepared by methods known per se, as described in the literature (for example in the standard works, such as Houben-Weyl, Methoden der organischen Chemie [Methods of Organic Chemistry], Georg-Thieme-Verlag, Stuttgart), and under reaction conditions which are known and are suitable for said reactions.
Preferred synthetic pathways are analogous to the syntheses of similar compounds described in WO 2018/007337 A2, WO 2019/238649 A2, WO 2020/225270 A2, WO 2020/225398 A2, WO 2021/078699 A2, WO 2021/078714 A2 and WO 2021/083934 A2.Use can be made here of variants which are known and described in the literature and exemplified below by the working examples.

In the formula I, preferred aryl groups are derived, for example, from the parent structures benzene, naphthalene, tetrahydronaphthalene, 9,10-dihydrophenanthrene, fluorene, indene and indane.

In the formula I, preferred heteroaryl groups are, for example, five-membered rings, such as, for example, furan, thiophene, selenophene, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole and 1,3,4-thiadiazole, six-membered rings, such as, for example, pyridine, pyridazine, pyrimidine, pyrazine, 1,3,5-triazine, 1,2,4-triazine and 1,2,3-triazine, or condensed rings, such as, for example, indole, isoindole, indolizine, indazole, benzimidazole, benzotriazole, purine, naphthimidazole, benzoxazole, naphthoxazole, benzothiazole, benzofuran, isobenzofuran, dibenzofuran, thieno[2,3b]thiophene, thieno[3,2b]thiophene, dithienothiophene, isobenzothiophene, dibenzothiophene, benzothiadiazothiophene, 2H-chromen (2H-1-benzopyran), 4H-chromene (4H-1-benzopyran) and coumarin (2H-chromen-2-one), or combinations of these groups.

In the formula I, preferred cycloaliphatic groups are cyclobutane, cyclopentane, cyclohexane, cyclohexene, cycloheptane, decahydronaphthalene, bicyclo[1.1.1]pentane, bicyclo[2.2.2]octane, spiro[3.3]heptane and octahydro-4,7-methanoindane.

Preferred spacer groups Sp are selected from the formula Sp'-X', so that the radical G-Sp- of formula I corresponds to the formula G-Sp'-X'-, where
- Sp': denotes straight-chain or branched alkylene having 1 to 20, preferably 1 to 12 C atoms, which is optionally mono- or polysubstituted by F, Cl, Br, I or CN and in which, in addition, one or more non-adjacent CH₂ groups may each be replaced, independently of one another, by -O-, -S-, -NH-, -NR⁰-, -SiR⁰⁰R⁰⁰⁰-, -CO-, -COO-, -OCO-, -OCO-O-, -S-CO-, -CO-S-, -NR⁰-CO-O-, -O-CO-NR⁰-, -NR⁰-CO-NR⁰-, -CH=CH- or -C≡C- in such a way that O and/or S atoms are not linked directly to one another,
- X': denotes -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- or a single bond,
- R⁰, R⁰⁰ and R⁰⁰⁰: each, independently of one another, denote H or alkyl having 1 to 12 C atoms, and
- Y^{x} and Y^{x'}: each, independently of one another, denote H, F, Cl or CN.
- X': is preferably -O-, -S-, -CO-, -COO-, -OCO-, -O-COO-, -CO-NR⁰-, -NR⁰-CO-, -NR⁰-CO-NR⁰- or a single bond.

Preferred groups Sp' are -(CH₂)ₚ₁-, -(CF₂)ₚ₁-, -(CH₂CH₂O)_{q1}-CH₂CH₂-, -(CF₂CF₂O)_{q1}-CF₂CF₂-, -CH₂CH₂-S-CH₂CH₂-, -CH₂CH₂-NH-CH₂CH₂-or -(SiR⁰⁰R⁰⁰⁰-O)ₚ₁₋, in which p1 is an integer from 1 to 12, q1 is an integer from 1 to 3, and R⁰⁰ and R⁰⁰⁰ have the meanings indicated above.

Particularly preferred groups -X'-Sp'- are -(CH₂)ₚ₁-, -O-(CH₂)ₚ₁-, -(CF₂)ₚ₁-, -O(CF₂)ₚ₁-, -OCO-(CH₂)ₚ₁- and -OC(O)O-(CH₂)ₚ₁-, in which p1 has the meaning indicated above.
Particularly preferred groups Sp' are, for example, in each case straight-chain ethylene, propylene, butylene, pentylene, hexylene, heptylene, octylene, nonylene, decylene, undecylene, dodecylene, octadecylene, perfluoroethylene, perfluoropropylene, perfluorobutylene, perfluoropentylene, perfluorohexylene, perfluoroheptylene, perfluorooctylene, perfluorononylene, perfluorodecylene, perfluoroundecylene, perfluorododecylene, perfluorooctadecylene, ethyleneoxyethylene, methyleneoxy-butylene, ethylenethioethylene, ethylene-N-methyliminoethylene, 1-methylalkylene, ethenylene, propenylene and butenylene.

Particularly preferred groups X' are -O- or a single bond.

In formula I, in a preferred embodiment the radical T preferably denotes 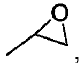 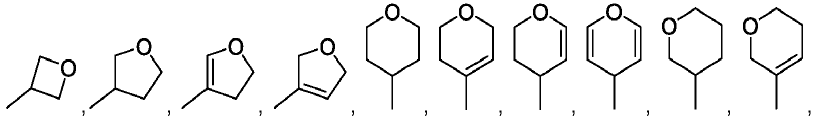 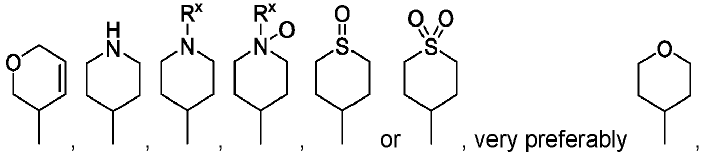 in which R^{x} denotes alkyl having 1 to 6 C atoms, preferably methyl.

In formula I, in another preferred embodiment the radical T denotes straight chain or branched alkyl having 1 to 12 C atoms, where one or more CH₂ groups in these radicals may each be replaced, independently of one another, by -C≡C- , -CH=CH-, 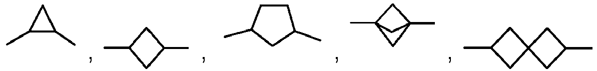 or -O-, in such a way that O atoms are not linked directly to one another, and in which one or more H atoms may be replaced by halogen, preferably by F.
In formula I and its sub-formulae, U and V preferably independently denote C-CI or C-F, very preferably C-F.

In formula I and its sub-formulae, the radical L preferably denotes Me, Et, n-Pr, iPr, CF₃, OCH₃, OCF₃, SCH₃, SCF₃, cyclopropyl, cyclobutyl, cyclopentyl, or cyclohexyl, more preferably Me, Et or OCH₃, in particular Me or Et.

In a preferred embodiment, the compounds of the formula I are selected from the compounds of the formulae IA-1a to IA-1f 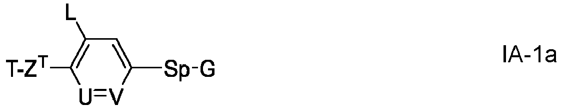 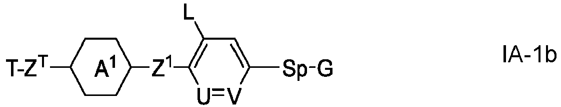 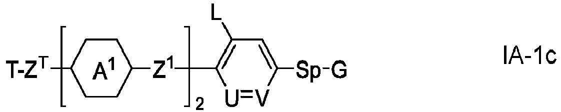 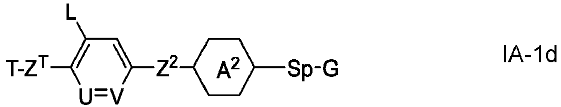 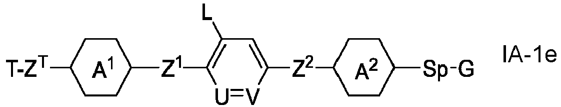 in which T, Z^{T}, 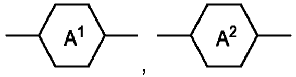 Z¹, Z², U, V, L, Sp and G have the meanings given above for formula I, and preferably
- T: denotes H, 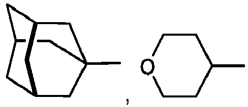 or straight chain or branched alkyl or alkoxy each having 1 to 7 C atoms or straight chain or branched alkenyl having 2 to 7 C atoms,
- Z^{T}: denotes CH₂O, OCH₂, CH₂CH₂, or a single bond,
- Z¹ and Z²,: identically or differently, denote CH₂O, OCH₂, CH₂CH₂, CF₂O, OCF₂, C(O)O, OC(O) or a single bond,
- A¹ and A²,: identically or differently, denote 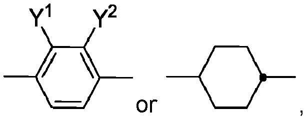
- Y¹ and Y²,: identically or differently, denote H, F of Cl, preferably F or Cl,
- Sp: denotes branched or unbranched 1,ω-alkylene having 1 to 12 C atoms, in which one or more non-adjacent CH₂-groups may be replaced by O,
- G: denotes -OP(O)(OH)₂, -PO(OH)₂, -COH(PO(OH)₂)₂ or -PO(OR^{V})₂,
- R^{V}: denotes methyl, ethyl or secundary or tertiary alkyl having 1 to 6 C atoms, and
- U, V and L: have the meanings given above for formula I.

In a preferred embodiment, the compounds of the formula I are selected from the compounds of the formula IA-2 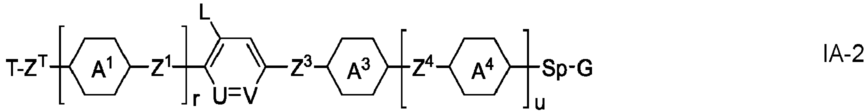 in which the occurring groups and parameters have the meanings given above for formula I and preferably
- A¹ and A⁴,: identically or differently, denote 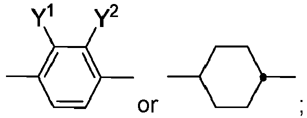
- A³-Z³: denotes 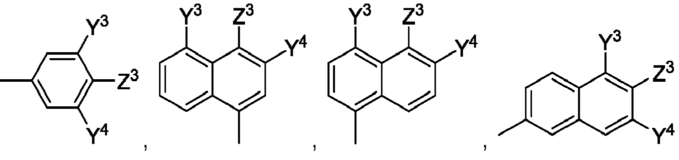 or 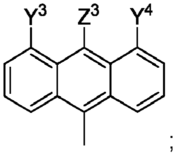
- Z^{T}: denotes a single bond, -CH₂O-, -OCH₂- or -CH₂CH₂-,
- L¹ and L²: identically or differently, denote F, CF₃ or Cl,
- Y¹ and Y²: identically or differently, have one of the meanings given above for Y and preferably denote H, F or Cl,
- Y³ and Y⁴,: identically or differently, have one of the meanings of Y¹ and Y² and preferably denote methyl, ethyl, isopropyl, cyclopropyl, cyclobutyl, cyclopentyl, cyclopentenyl, cyclohexyl, cyclohexenyl, methoxy, trifluoromethyl, trifluoromethoxy, or trifluoromethylthio,
- Z³: denotes CH₂ or O,
- Z¹, Z²,: independently of one another, denote a single bond, -C(O)O-, -OC(O)-, -CF₂O-, -OCF₂-, -CH₂O-, OCH₂- or -CH₂CH₂-,
- G: denotes -OP(O)(OH)₂, -PO(OH)₂, -COH(PO(OH)₂)₂ or -PO(OR^{V})₂,
- R^{V}: denotes methyl, ethyl or secundary or tertiary alkyl having 1 to 6 C atoms and
- r and u: independently are 0, 1 or 2.

According to another aspect of the invention the molecular layer comprises one or more chiral non-racemic compounds selected from the compounds of the formula I.

The molecular layers obtained from chiral compounds of the formula I enable memristic devices with significantly reduced stochastic noise and faster switching, reducing the read and write error rate, which has a positive effect on energy-efficiency. In addition, increased tunnel current are observed allowing for the integration to smaller junction sizes.

Preferably, the chiral compound has an enantiomeric excess (ee) of above 50%, preferably above 80%, 90%, or 95%, more preferably above 97%, in particular above 98%.

Chirality is achieved by a branched chiral group Sp of formula I above having one or more, preferably one or two, very preferably one, asymmetrically substituted carbon atom (or: asymmetric carbon atom, C*), hereinafter referred to as Sp*. In Sp* the asymmetric carbon atom is preferably linked to two differently substituted carbon atoms, a hydrogen atom and a substituent selected from the group halogen (preferably F, Cl, or Br), alkyl or alkoxy with 1 to 5 carbon atoms in each case, and CN.

The chiral organic radical Sp* preferably has the formula 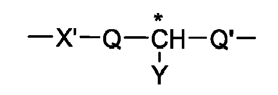 in which
- X': has the meanings defined above and preferably denotes -CO-O-, -O-CO-,-O-CO-O-, -CO-, -O-, -S-, -CH=CH-, -CH=CH-COO- or a single bond, more preferably -CO-O-, -O-CO-, -O- or a single bond, very preferably -O- or a single bond,
- Q and Q': identically or differently, denote a single bond or optionally fluorinated alkylene having 1 to 10 carbon atoms, in which a CH₂ group not linked with X can also be replaced by -O-, -CO-, -O-CO-, -CO-O- or -CH=CH-, preferably alkylene having 1 to 10 carbon atoms or a single bond, particularly preferably -(CH₂)ₙ₅- or a single bond,
- n5: is 1, 2, 3, 4, 5, or 6,
- Y: denotes optionally fluorinated alkyl having 1 to 15 carbon atoms, in which one or two non-adjacent CH₂ groups can also be replaced by -O-, -CO-,-O-CO-, -CO-O- and/or -CH=CH-, further CN or halogen, preferably optionally fluorinated alkyl or alkoxy having 1 to 7 C atoms, -CN or Cl, particularly preferably -CH₃, -C₂H₅, -CF₃ or Cl,

In addition, chirality is achieved by a chiral group T of formula I above having one or more, preferably one or two, very preferably one, asymmetrically substituted carbon atom (or: asymmetric carbon atom, C*), hereinafter referred to as R*.

In R* the asymmetric carbon atom is preferably linked to two differently substituted carbon atoms, a hydrogen atom and a substituent selected from the group halogen (preferably F, Cl, or Br), alkyl or alkoxy with 1 to 5 carbon atoms in each case, and CN.

The chiral organic radical preferably has the formula 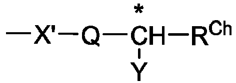 in which
- X': has the meanings defined above for formula I and preferably denotes -CO-O-, -O-CO-, -O-CO-O-, -CO-, -O-, -S-, -CH=CH-, -CH=CH-COO- or a single bond, more preferably -CO-O-, -O-CO-, -O-, or a single bond, very preferably -O- or a single bond,
- Q: denotes a single bond or optionally fluorinated alkylene having 1 to 10 carbon atoms, in which a CH₂ group not linked with X can also be replaced by -O-, -CO-, -O-CO-, -CO-O- or -CH=CH-, preferably alkylene having 1 to 5 carbon atoms or a single bond, particularly preferably -CH₂-, -CH₂CH₂- or a single bond,
- Y: denotes optionally fluorinated alkyl having 1 to 15 carbon atoms, in which one or two non-adjacent CH₂ groups can also be replaced by -O-, -CO-, -O-CO-, -CO-O- and/or -CH=CH-, further CN or halogen, preferably optionally fluorinated alkyl or alkoxy having 1 to 7 C atoms, -CN or Cl, particularly preferably -CH₃, -C₂H₅, -CF₃ or Cl,
- R^{Ch}: denotes an alkyl group having 1 to 15 carbon atoms that is different from Y, in which one or two non-adjacent CH₂ groups can also be replaced by-O-, -CO-, -O-CO-, -CO-O- and/or -CH=CH-, preferably denotes straight-chain alkyl having 1 to 10, in particular 1 to 7, carbon atoms, in which the CH₂ group linked to the asymmetric carbon atom can be replaced by -O-, -O-CO- or -CO-O-.

Preferably, the first electrodes and/or second electrodes of each cell are made from a metal, a conductive alloy, a conductive ceramic, a semiconductor, a conductive oxidic material, conductive or semi conductive organic molecules or a layered conductive 2D material. The first and/or second electrode may comprise combinations of more than one of said materials, for example in form of a multi-layer system. The material of the first and the second electrode may be chosen identically or differently.

Suitable metals include Ag, Al, Au, Co, Cr, Cu, Mo, Nb, Ni, Pt, Ru, W, Pd, Pt, wherein Al, Cr and Ti are preferred.

Suitable conductive ceramic materials include CrN, HfN, MoN, NbN, TiO₂, RuO₂, VO₂, NSTO (niobium-doped strontium titanate), TaN and TiN, WN, WCN, VN and ZrN, wherein TiN is preferred.

Suitable semiconductor materials include indium tin oxide (ITO), indium gallium oxide (IGO), InGa-α-ZnO (IGZO), aluminium-doped zinc oxide (AZO), tin-doped zinc oxide (TZO), fluorine-doped tin oxide (FTO) and antimony tin oxide.

Suitable element semiconductors include Si, Ge, C (diamond, graphite, graphene, fullerene), α-Sn, B, Se and Te. Suitable compound semiconductors include group III-V semiconductors, in particular GaAs, GaP, InP, InSb, InAs, GaSb, GaN, TaN, TiN, MoN, WN, AIN, InN, Alx Ga1-x As and Inx Ga1-x Ni, group II-VI semiconductors, in particular ZnO, ZnS, ZnSe, ZnTe, CdS, CdSe, CdTe, Hg(1-x) Cd(x) Te, BeSe, BeTex and HgS; and group III-VI semiconductors, in particular GaS, GaSe, GaTe, InS, InSex and InTe, group I-III-VI semiconductors, in particular CuInSe2, CuInGaSe2, CuInS2 and CuInGaS2, group IV-IV semiconductors, in particular SiC and SiGe, group IV-VI semiconductors, in particular SeTe.

Suitable highly doped semiconductor materials include p+Si, n+Si. An example of a suitable layered conductive 2D material is graphene.

Suitable semiconductive organic molecules include polythiophene, tetracene, pentacene, phthalocyanines, PTCDA, MePTCDI, quinacridone, acridone, indanthrone, flaranthrone, perinone, AIQ3 , and mixed systems, in particular PEDOT:PSS and polyvinylcarbazole/TLNQ complexes.

In a preferred embodiment, the first and second electrodes, identically or differently, comprise a material selected from the group consisting of Ag, Al, Au, Co, Cr, Cu, Mo, Nb, Ni, Pt, Ru, Si, W, CrN, HfN, MoN, NbN, TiN, TaN, WN, WCN, VN and ZrN.

More preferably, the first and second electrodes, identically or differently, comprise, preferably consist of a metal nitride selected from CrN, HfN, MoN, NbN, TiN, TaN, WN, tungsten carbide nitride (WCN), VN and ZrN.

In particular, the first electrode consist of a metal nitride selected from CrN, HfN, MoN, NbN, TiN, TaN, WN, WCN, VN and ZrN, and the second electrode consists of TiN.

Very particularly, the first and the second electrode both consist of TiN.

In the following description of the illustrative embodiments of the invention, identical or similar components and elements are denoted by identical or similar reference numbers, where repeated description of these components or elements is avoided in individual cases. The figures only depict the subject-matter of the invention diagrammatically.

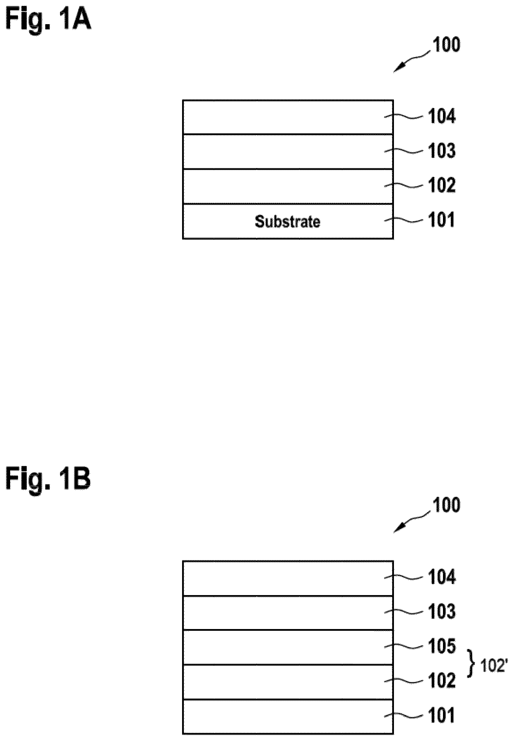

FIG. 1A illustrates a nanoscale non-volatile solid state resistive device 100 having a molecular switching layer 103 according to an embodiment of the present invention. Device 100 is a two-terminal memory in the present embodiment. Device 100 includes a first electrode 102, a molecular switching layer 103, and a second electrode 104. Device 100 is a resistive memory device in the present embodiment, but may be other types of device in other embodiments. The molecular switching layer can be selectively set to various resistance values by applying a voltage to the electrodes and reset, using appropriate control circuitry. The resistance of the device 100 changes according to the orientation of the molecular dipoles of the molecular switching layer 103. Device 100 is formed over an outer semiconductor substrate 101. The semiconductor substrate may be a silicon substrate or a compound substrate of a III-V or II-VI type. In an embodiment, the substrate is not made of semiconductor material, e.g., made of plastic.

Particularly suitable substrates are selected from:
- element semiconductors, such as Si, Ge, C (diamond, graphite, graphene, fullerene), α-Sn, B, Se and Te;
- compound semiconductors, preferably
   - group III-V semiconductors, in particular GaAs, GaP, InP, InSb, InAs, GaSb, GaN, TaN, TiN, MoN, WN, AIN, InN, AlₓGa₁₋ₓAs and InₓGa₁₋ₓNi,
   - group II-VI semiconductors, in particular ZnO, ZnS, ZnSe, ZnTe, CdS, CdSe, CdTe, Hg₍₁₋ₓ₎Cd₍ₓ₎Te, BeSe, BeTeₓ and HgS;
   - group III-VI semiconductors, in particular GaS, GaSe, GaTe, InS, InSeₓ and InTe,
   - group I-III-VI semiconductors, in particular CuInSe₂, CuInGaSe₂, CuInS₂ and CuInGaS₂,
   - group IV-IV semiconductors, in particular SiC and SiGe,
   - group IV-VI semiconductors, in particular SeTe;
- organic semiconductors, in particular polythiophene, tetracene, pentacene, phthalocyanines, PTCDA, MePTCDI, quinacridone, acridone, indanthrone, flaranthrone, perinone, AIQ₃, and mixed systems, in particular PEDOT:PSS and polyvinylcarbazole/TLNQ complexes;
- metals, in particular Ta, Ti, Co, Mo, Pt, Ru, Au, Ag, Cu, Al, W and Mg;
- conductive oxidic materials, in particular indium tin oxide (ITO), indium gallium oxide (IGO), InGa-α-ZnO (IGZO), aluminium-doped zinc oxide (AZO), tin-doped zinc oxide (TZO), fluorine-doped tin oxide (FTO) and antimony tin oxide.

Preference is given to the use of crystalline silicon as substrate 101, where silicon wafers having a (100) surface are particularly preferred. Silicon wafers whose surface is oriented at (100) are employed as conventional substrate in microelectronics and are available in high quality and with a low proportion of surface defects.

In the switching devices according to the invention, the molecules of the molecular layer 103 are bonded to the first electrode 102 by means of the anchoring group G as defined above.

The molecular layer may optionally be bonded to a relatively thin (preferably 0.5 - 5 nm thick) oxidic interlayer 105, for example TiO₂, Al₂O₃, ZrO₂, HfO₂, or SiO₂, which is located on the first electrode 102, thus in this embodiment, the first electrode comprises a first layer comprising the material defined in claim 1 and a second oxidic layer to which the molecular layer 103 is bonded (Fig. 1B). Hence, first electrode 102 and interlayer 105 are operable as an alternative first electrode 102'.

The molecular layer of the present invention is a layer of electrically insulating, nonconducting and non-semiconducting organic compounds.

The molecular layer is essentially formed from precursors of the formula I. Preferably, the precursors used for the formation of the molecular layer consist of compounds of the formula I.

The thickness of the molecular layer is preferably 10 nm or less, particularly preferably 5 nm or less, very particularly preferably 3 nm or less.

The molecular layer may consist of one, two, three or more molecule layers comprising compounds of the formula I.

The molecular layer employed in accordance with the invention is preferably a molecular monolayer.

In an embodiment, the molecular layer is a self-assembled monolayer (SAM).

The production of self-assembled monolayers is known to the person skilled in the art; a review is given, for example, in A. Ulman, Chem. Rev. 1996, 96, 1533-1554.

The degree of coverage of the substrate is preferably 90% to 100%, particularly preferably 95% to 100%, very particularly preferably 98% to 100%.

Preferably, the second electrode 104 consists of TiN.

In an embodiment, first electrodes 102, which in the embodiment of Figure 1A are implemented in the form of conductor tracks which run perpendicular to the drawing plane, are arranged on the substrate 101.

A second electrode 104, which, like the first electrode 102, is in the form of a conductor track, is arranged on the side of the molecular layer 103 facing away from the substrate 101. However, the second electrode 104 is rotated by 90° relative to the first electrode 102, so that a cross-shaped arrangement arises. This arrangement is also called a crossbar array, where the 90° angle is selected here as an example and arrangements in which second electrodes 104 and first electrodes 102 cross at an angle deviating from the right angle are also conceivable. A switching device 100, which is formed from a layer system having, in this sequence, a second electrode 104, a molecular layer 103 and a first electrode 102, is arranged at each crossing point between a second electrode 104 and a first electrode 102. In an embodiment a diode is also assigned to each switching device 100.

The crossbar array enables each switching device 100 to be addressed electrically by applying a voltage between the corresponding first electrode 102 and second electrode 104.

The production and structuring of the electrodes is carried out by means of processes known to the person skilled in the art and is explained in greater detail below with reference to the working examples.

The structures of the electrodes 102,104 can be produced by means of structuring methods known to the person skilled in the art from microelectronics. For example, a lithography method can be employed for the production of the first electrodes 102. In this, a metal layer is applied to the substrate 101 by means of vapour deposition. The metal layer is subsequently coated with a photoresist, which is exposed with the structures to be produced. After development and, where necessary, baking of the resist, the parts of the metal layer that are not required are removed, for example, by wet-chemical etching. The remaining resist is subsequently removed, for example using a solvent.

A further possibility for the production of the electrodes 102, 104 is vapour deposition with the aid of a shadow mask. In this method, a mask whose openings correspond to the shape of the electrodes 102,104 to be produced is placed on the component and a metal is subsequently applied by vapour deposition. The metal vapour is only able to precipitate and form the electrode 102, 104 on the component in the areas not covered by the mask.

Suitable and preferred processes for the fabrication of the switching device according to the invention are published in EP3813132, paragraph [0113] to [0126]. The compounds according to the invention can be used as described therein.

A substrate 101 whereon a plurality of devices 100 is to be defined is provided.The substrate is silicon (p doped, resistivity <0.001 Ω cm⁻¹, prime grade) in the present embodiment. In a preferred embodiment, the silicon substrate comprises a SiO₂ layer which serves as an isolating layer and improves derivatization. In other embodiments, other semiconductor materials such as III-V and II-VI type semiconductor compounds may be used as the substrate. Device 100 may be formed as part of a front-end process or a back-end process depending on implementation. Accordingly, substrate 101 may include one or more layers of material formed and patterned thereon when the substrate is provided for the present process.

A first electrode is formed over substrate 101 using any deposition process, such as, for example, chemical vapor deposition (CVD), plasma enhanced CVD (PECVD), radio-frequency CVD (RFCVD), physical vapor deposition (PVD), atomic layer deposition (ALD), molecular beam deposition (MBD), pulsed laser deposition (PLD), and/or liquid source misted chemical deposition (LSMCD), and/or sputtering, or another deposition or growth process to form at least a top portion of the first electrode. The bottom electrode preferably should comprise a material having a high voltage threshold for ion migration and it can be blanket or structured by photolithography or other advanced lithography processes known to a person skilled in the art, e.g. nano-imprint lithography or dip-pen lithography.

Optionally, the first electrode is treated with oxygen, argon or nitrogen plasma or UV/ozone in order to obtain a hydrophilic oxidic surface which is populated with hydroxyl groups. It is clear that an oxidic surface of this type merely serves for surface modification with the aim of possible derivatisation via condensation reactions and does not represent an insulator layer or interlayer in the true sense. Sufficiently large tunnel currents through this oxidic surface are possible owing to the low thickness in the order of 1 nm.

A molecular layer 103 is formed over the first electrode 102.

The deposition of the molecular layer onto the first electrode is carried out with the pure substance or from solution, preferably from solution. Suitable deposition methods and solvents are known to the person skilled in the art; examples are spin coating or dip coating.

In an embodiment, the anchoring group G of the compounds forming the molecular layer, in particular of the compounds of the formula I and their sub-formulae, is selected from OH, 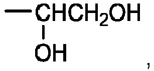 -CH(CH₂OH)₂, -COOH, and -O-C(O)-OR², in which R² denotes primary or secondary or tertiary alkyl having 1 to 6 C atoms, preferably tert.-butyl; preferably, the anchoring group G is selected from the group consisting of OH, 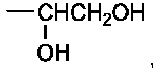 -CH(CH₂OH)₂ and -COOH and where the molecular layer is formed in an ALD process as described in WO2021/083934. According to another aspect of the present invention there is provided an ALD process in which the first reactant of said ALD process has fluorine atoms associated therewith and wherein the anchoring group G of the compounds forming the molecular layer, in particular of the compounds of the formula I and their sub-formulae, is selected from -OSiR₃, -COOSiR₃, -CH(CH₂OSiR₃)₂, 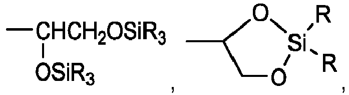 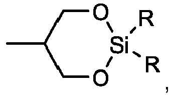 and -O-C(O)-OSiR₃, in which R, on each occurrence, identically or differently, denotes alkyl having 1 to 6 C atoms, preferably methyl, ethyl or isopropyl, very preferably methyl.

The molecules of the molecular layer are preferably bonded to the first electrode by chemisorption or covalently, more preferably covalently. The bonding is carried out by known methods which are familiar to the person skilled in the art, for example by condensation with hydroxyl groups located on the surface of the substrate.

In an alternative embodiment, the molecular layer 103 can also be linked to a first electrode not directly but via a thin oxidic adhesion layer 105 derived from a metal different from that of the first electrode (e.g. Al₂O₃, ZrO₂) and which is deposited onto the first electrode using the deposition techniques mentioned above for the first electrode, preferably CVD.

Preferred is grafting of a molecular layer directly onto a titanium nitride first electrode 102 by means of molecules of formula I in which the anchor group G is a phosphonic acid group.

In a preferred embodiment, the device is annealed after deposition of the monolayer. The annealing is carried out at a temperature of greater than 20°C and less than 300°C, preferably at greater than 50°C and less than 200°C, particularly preferably at greater than 90°C and less than 150°C. The time duration of the annealing is 1 to 48 h, preferably 4 to 24 h, particularly preferably 8 to 16 h.

According to another aspect of the invention the monolayer is fabricated from one or more compounds of formulae I in which the anchor group G denotes - SO₂OR^{V}, -OP(O)(OR^{V})₂, -PO(OR^{V})₂, -C(OH)(PO(OR^{V})₂)₂, -COOR^{v} or -Si(OR^{V})₃ where R^{V} denotes alkyl having 1 to 20 C atoms, preferably a secondary or tertiary alkyl having up to 20 C atoms. These compounds are distinguished by a particularly high solubility and are well suitable for industrial processes such as spin coating. In addition, it is possible to process these compounds by gas phase deposition. The compounds serve as precursors for the corresponding free acids which are obtained in situ by thermal treatment of the compounds after deposition onto the first electrode. The first electrode is then heated to a temperature between 60°C and 300°C, preferably between 100°C and 250°C, in particular between 140°C and 180°C.

The first electrode 102 is patterned to obtain an electrode extending along a direction (e.g., horizontal direction). A plurality of first electrodes extending along the first direction in parallel is formed at this step.
Patterned second electrodes are formed on the molecular layer 103 by a lift-off process using a known processing sequence including a lift-off photoresist, patterning step, electrode deposition, and lift off, or using a photoresist.

The second electrode 104 can be deposited, e.g., by sputtering or atomic layer deposition, preferably by sputtering.

According to another aspect of the present invention, a plurality of cells is arranged in a three dimensional array of cells. Accordingly, the array extends in two directions of a plane, which may be defined by a substrate onto which the electronic element is formed, and may also extend in a vertical direction perpendicular to this plane. A number of cells arranged in the each of the two directions or dimensions of the plane may be very high, ranging from at least two to several thousands, millions or even billions of cells. For example, in a configuration of 1024 cells in an x-direction and 1024 cells in a y-direction, a single two dimensional layer of cells comprises 1048576 cells. Such a two-dimensional arrangement of cells, wherein each of the cells is located at a crossing of two orthogonal electrode lines is known as crossbar array.

The number of levels or layers of cells arranged in the vertical direction or dimension is typically lower and ranges from 2 to at least 64, preferably up to at least 1024 or even higher. Preferably, the array comprises at least 16 levels of cells, more preferably at least 32 levels of cells and most preferred at least 64 levels of cells. Such a three-dimensional arrangement of cells is known as a 3D crossbar array or 3D cross point device.

### Examples

### Synthesis Examples

### Example 1: 11-(4-cyclohexyl-2,3-difluoro-5-methyl-phenoxy)undecylphosphonic acid

Step 1: 1-Benzyloxy-4-bromo-2,3-difluoro-5-methyl-benzene 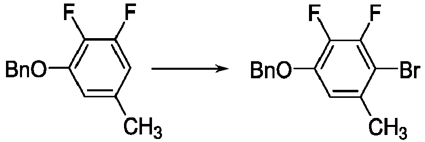 1-Benzyloxy-2,3-difluoro-5-methyl-benzene (20.0 g, 85.38 mmol) is dissolved in acetonitrile (200 ml) under nitrogen. N-bromosuccinimide (19.8 g) is added and the mixture is heated at reflux for 2 hours. The reaction is cooled and then concentrated to dryness to leave a waxy solid. Heptane (200 ml) is added and the mixture warmed to 40°C then filtered and the retained solids washed with heptane. The filtrates are concentrated to dryness, to leave a pale yellow waxy solid. The material is dissolved in heptane (5 vols) and filtered through silica eluting with heptane. The product containing fractions are combined and concentrated to dryness to leave an off-white solid, which is recrystallized from isopropanol to give 1-benzyloxy-4-bromo-2,3-difluoro-5-methyl-benzene as a white solid; mp. 71-73°C.
¹H NMR (400 MHz, CDCl₃) δ ppm 2.35 (3 H, m), 5.14 (2 H, s), 6.73 (1 H, dd, J=7.6, 1.8 Hz), 7.32 - 7.47 (5 H, m).

Step 2: 1-Benzyloxy-4-(cyclohexen-1-yl)-2,3-difluoro-5-methyl-benzene 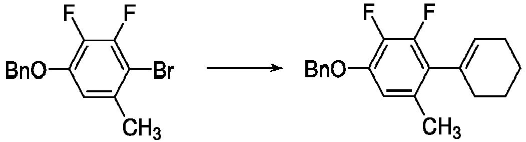 1-benzyloxy-4-bromo-2,3-difluoro-5-methyl-benzene (11.7 g) is dissolved in THF (117 ml), n-butyl lithium (2.5 M, 16.4 ml) is added over 25 minutes at -74°C and the reaction mixture is stirred for 1 hr at < -70°C. Cyclohexanone (4.6 ml) is added dropwise and the solution is allowed to warm to room temperature overnight. The solution is cooled to 0°C and quenched with water (20 ml). The reaction mixture is partitioned between CH₂Cl₂ (75 ml) and water (50 ml) and the aqueous is extracted with CH₂Cl₂ (2 × 50 ml). The organics are combined and washed with water then dried (MgSO₄), filtered and concentrated to dryness to leave a yellow oil. The crude oil is purified on silica eluting with an increasing gradient of CH₂Cl₂ in heptane 0-100%. Product containing fractions are combined and concentrated to dryness to yield a yellow solid, which is not purified further. The crude cyclohexanol intermediate is dissolved in toluene (92 ml) and p-toluenesulfonic acid monohydrate (0.53 g, 10 mol%) is added. The mixture is heated at reflux for 90 minutes and concentrated to dryness to leave a brown oil. The material is dissolved in 10% CH₂Cl₂/heptane (5 vols) and filtered through silica eluting with 20% DCM/heptane. Product containing fractions are combined and concentrated to dryness to an almost colourless oil (8.2 g) that crystallised slowly on standing. The solids are recrystallized from methanol to give 1-benzyloxy-4-(cyclohexen-1-yl)-2,3-difluoro-5-methyl-benzene as a white solid; mp. 57-60°C.
¹H NMR (400 MHz, CDCl₃) δ ppm 1.66 - 1.83 (4 H, m), 2.07 - 2.25 (7 H, m), 5.13 (2 H, s), 5.59 (1 H, m), 6.62 (1 H, dd, *J*=7.5, 1.5 Hz), 7.32 - 7.49 (5 H, m).

Step 3: 4-Cyclohexyl-2,3-difluoro-5-methyl-phenol 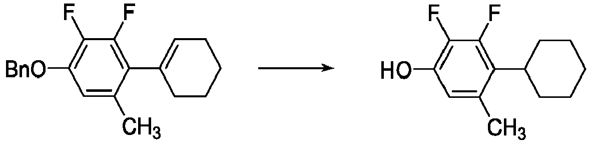 A solution of 1-benzyloxy-4-(cyclohexen-1-yl)-2,3-difluoro-5-methyl-benzene (5.0 g) in methanol (100 ml) is added to 5% Pd/C (0.29 g, 0.50% wetted, 5 weight %) and the reaction heated at 100°C under 10 bar hydrogen pressure overnight. The reaction is cooled to room temperature, filtered and the filtrates concentrated to dryness to give 4-cyclohexyl-2,3-difluoro-5-methyl-phenol as an off-white solid; mp. 71-74°C.
¹H NMR (400 MHz, DMSO-*d₆*) δ ppm 1.11 - 1.38 (3 H, m), 1.53 - 1.84 (7 H, m), 2.08 - 2.25 (3 H, s), 2.66 (1 H, t, *J*=11.4 Hz), 6.54 (1 H, d, *J*=8.2 Hz), 9.92 (1 H, s).

Step 4: 4-Cyclohexyl-1-(11-diethoxyphosphorylundecoxy)-2,3-difluoro-5-methylbenzene 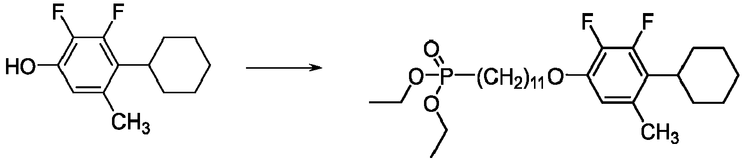 4-Cyclohexyl-2,3-difluoro-5-methyl-phenol (4.4 g) is dissolved in butanone (57 ml). Diethyl (11-bromoundecyl) phosphonate (9.4 g, 1.30 eq) and sodium iodide (0.15 g, 5 mol%) are added followed by potassium carbonate (10.8 g, 4.0 eq) and the mixture is heated at reflux under nitrogen overnight. The reaction is cooled and filtered and the solids are washed with acetone. The filtrates are concentrated to dryness and the crude material is dissolved in CH₂Cl₂ and filtered through silica eluting with 10% ethyl acetate/CH₂Cl₂ (9 × 200 ml). to give 4-cyclohexyl-1-(11-diethoxyphosphorylundecoxy)-2,3-difluoro-5-methyl-benzene as a colourless oil.
¹H NMR (400 MHz, CDCl₃) δ ppm 1.20 - 1.49 (24 H, m), 1.50 - 1.89 (12 H, m), 2.25 (3 H, s), 2.67 (1 H, t, *J*=11.9 Hz), 3.97 (2 H, t, *J*=6.5 Hz), 4.00 - 4.17 (4 H, m), 6.49 (1 H, d, *J*=7.6 Hz).

Step 5: 11-(4-cyclohexyl-2,3-difluoro-5-methyl-phenoxy)undecylphosphonic acid 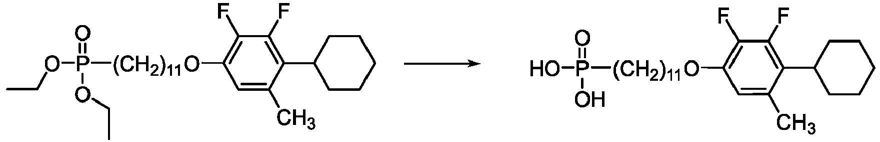 4-Cyclohexyl-1-(11-diethoxyphosphorylundecoxy)-2,3-difluoro-5-methyl-benzene (7.0 g) is dissolved in dichloromethane (105 ml). Trimethylsilyl bromide (18 ml, 10.0 eq) is added and the solution is stirred at room temperature overnight. The reaction mixture is concentrated to dryness to a yellow oil then methanol is added and concentrated back down to dryness to a yellow oil. Methanol is added and the solution stored at -20°C overnight. The solids are filtered-off, washed with cold methanol and dried. The crude product is recrystallized from dichloromethane and acetonitrile to give 11-(4-cyclohexyl-2,3-difluoro-5-methyl-phenoxy)undecylphosphonic acid as a white solid. ¹H NMR (400 MHz, THF) δ ppm 1.23 - 1.52 (17 H, m), 1.53 - 1.92 (13 H coalesced with residual THF, m), 2.26 (3 H, s), 2.75 (1 H, t, *J*=11.9 Hz), 3.99 (2 H, t, *J*=6.5 Hz), 6.63 (1 H, d, *J*=7.7 Hz).
¹⁹F NMR (376 MHz, THF) δ ppm -165.69 (d, *J*=19.1 Hz), -142.45 (d, *J*=19.1 Hz).
³¹P NMR (162 MHz, THF) δ ppm 30.66.

In analogy to the above described syntheses the following compounds are obtained: Compounds of the formula IA-1a:

| No. | T | Z^{T} | 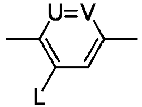 | Sp | G |
|---|---|---|---|---|---|
| | H | - | 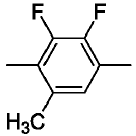 | OCF₂CF₂ | -PO(OH)₂ |
| | CH₃ | - | 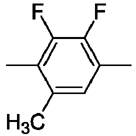 | O(CH₂)₃CH₂ | -PO(OH)₂ |
| | C₂H₅O | - | 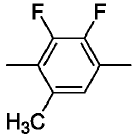 | O(CH₂)₄CH₂ | -PO(OH)₂ |
| | C₃H₇ | - | 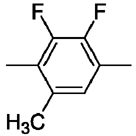 | O(CH₂)₅CH₂ | -PO(OH)₂ |
| | C₄H₉ | - | 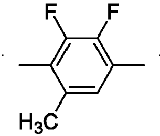 | O(CH₂)₆CH₂ | -PO(OH)₂ |
| | C₅H₁₁ | - | 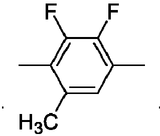 | O(CH₂)₈CH₂ | -PO(OH)₂ |
| | CH₂=CH | - | 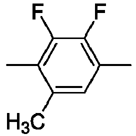 | O(CH₂)₁₀CH₂ | -PO(OH)₂ |
| | 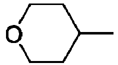 | - | 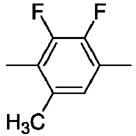 | 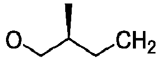 | -PO(OH)₂ |
| | 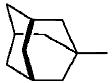 | CH₂O | 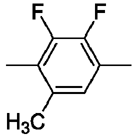 | O(CH₂)₄O(CH₂)₄ | -PO(OH)₂ |
| | H | - | 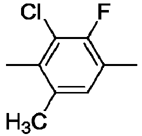 | OCF₂CF₂ | -PO(OH)₂ |
| | CH₃ | - | 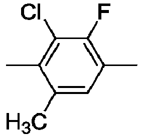 | O(CH₂)₃CH₂ | -PO(OH)₂ |
| | C₂H₅O | - | 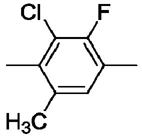 | O(CH₂)₄CH₂ | -PO(OH)₂ |
| | C₃H₇ | - | 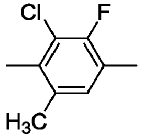 | O(CH₂)₅CH₂ | -PO(OH)₂ |
| | C₄H₉ | - | 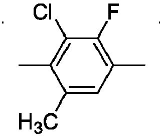 | O(CH₂)₆CH₂ | -PO(OH)₂ |
| | C₅H₁₁ | - | 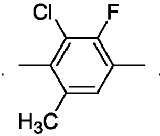 | O(CH₂)₈CH₂ | -PO(OH)₂ |
| | CH₂=CH | - | 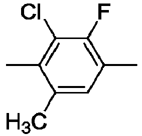 | O(CH₂)₁₀CH₂ | -PO(OH)₂ |
| | 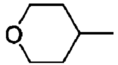 | - | 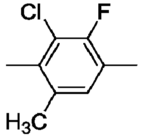 | 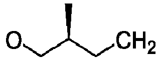 | -PO(OH)₂ |
| | 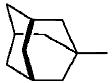 | CH₂O | 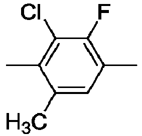 | O(CH₂)₄O(CH₂)₄ | -PO(OH)₂ |
| | H | - | 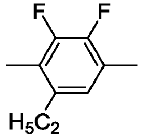 | OCF₂CF₂ | -PO(OH)₂ |
| | CH₃ | - | 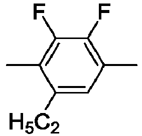 | O(CH₂)₃CH₂ | -PO(OH)₂ |
| | C₂H₅O | - | 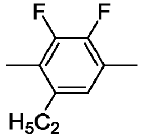 | O(CH₂)₄CH₂ | -PO(OH)₂ |
| | C₃H₇ | - | 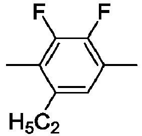 | O(CH₂)₅CH₂ | -PO(OH)₂ |
| | C₄H₉ | - | 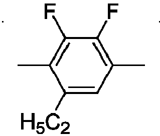 | O(CH₂)₆CH₂ | -PO(OH)₂ |
| | C₅H₁₁ | - | 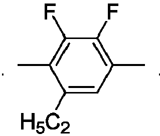 | O(CH₂)₈CH₂ | -PO(OH)₂ |
| | CH₂=CH | - | 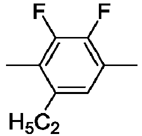 | O(CH₂)₁₀CH₂ | -PO(OH)₂ |
| | 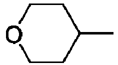 | - | 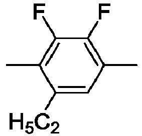 | 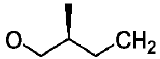 | -PO(OH)₂ |
| | 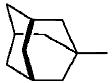 | CH₂O | 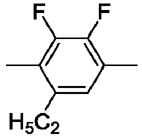 | O(CH₂)₄O(CH₂)₄ | -PO(OH)₂ |
| | H | - | 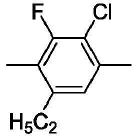 | OCF₂CF₂ | -PO(OH)₂ |
| | CH₃ | - | 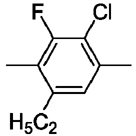 | O(CH₂)₃CH₂ | -PO(OH)₂ |
| | C₂H₅O | - | 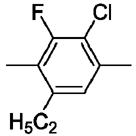 | O(CH₂)₄CH₂ | -PO(OH)₂ |
| | C₃H₇ | - | 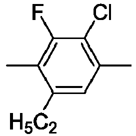 | O(CH₂)₅CH₂ | -PO(OH)₂ |
| | C₄H₉ | - | 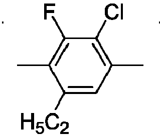 | O(CH₂)₆CH₂ | -PO(OH)₂ |
| | C₅H₁₁ | - | 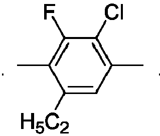 | O(CH₂)₈CH₂ | -PO(OH)₂ |
| | CH₂=CH | - | 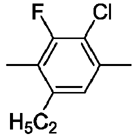 | O(CH₂)₁₀CH₂ | -PO(OH)₂ |
| | 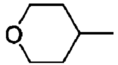 | - | 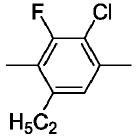 | 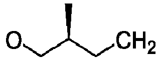 | -PO(OH)₂ |
| | 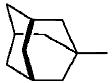 | CH₂O | 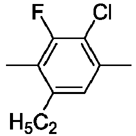 | O(CH₂)₄O(CH₂)₄ | -PO(OH)₂ |

Compounds of the formula IA-1b:

| No. | T | Z^{T} | 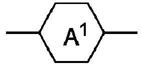 | Z¹ | 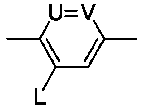 | Sp | G |
|---|---|---|---|---|---|---|---|
| | H | - | 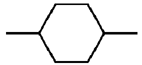 | | 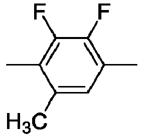 | OCH₂CH₂ | - PO(OH)₂ |
| | CH₃ | - | 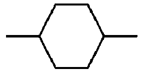 | | 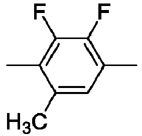 | O(CH₂)₃CH₂ | - PO(OH)₂ |
| | C₂H₅ | - | 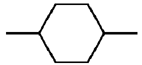 | | 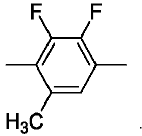 | O(CH₂)₄CH₂ | - PO(OH)₂ |
| | C₃H₇ | - | 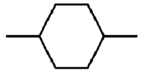 | | 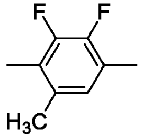 | O(CH₂)₅CH₂ | - PO(OH)₂ |
| | C₄H₉ | - | 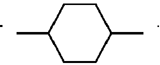 | | 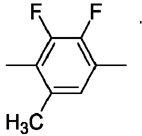 | O(CH₂)₆CH₂ | - PO(OH)₂ |
| | C₅H₁₁ | - | 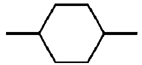 | | 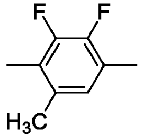 | O(CH₂)₈CH₂ | - PO(OH)₂ |
| | CH₂=CH | - | 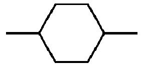 | | 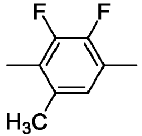 | O(CH₂)₁₀CH₂ | - PO(OH)₂ |
| | 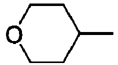 | | 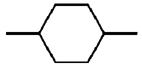 | | 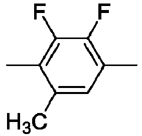 | 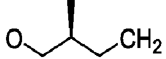 | PO(OH)₂ |
| | 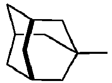 | CH₂O | 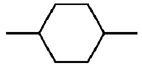 | | 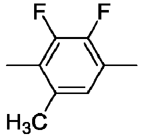 | O(CH₂)₄O(CH₂)₄ | - PO(OH)₂ |
| | H | - | 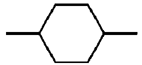 | | 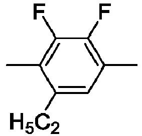 | OCH₂CH₂ | - PO(OH)₂ |
| | CH₃ | - | 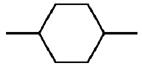 | | 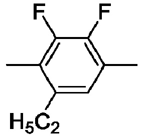 | O(CH₂)₃CH₂ | - PO(OH)₂ |
| | C₂H₅ | - | 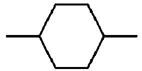 | | 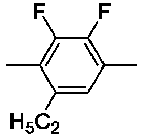 | O(CH₂)₄CH₂ | - PO(OH)₂ |
| | C₃H₇ | - | 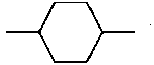 | | 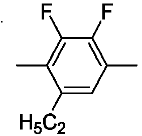 | O(CH₂)₅CH₂ | - PO(OH)₂ |
| | C₄H₉ | - | 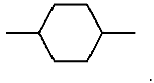 | | 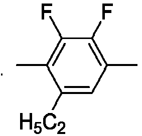 | O(CH₂)₆CH₂ | - PO(OH)₂ |
| | C₅H₁₁ | - | 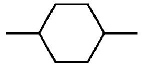 | | 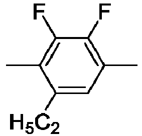 | O(CH₂)₈CH₂ | - PO(OH)₂ |
| | CH₂=CH | - | 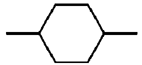 | | 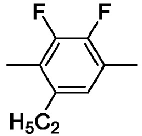 | O(CH₂)₁₀CH₂ | - PO(OH)₂ |
| | 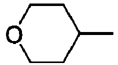 | | 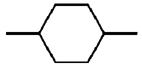 | | 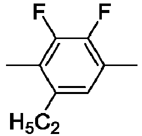 | 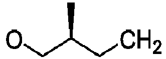 | PO(OH)₂ |
| | 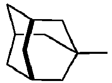 | CH₂O | 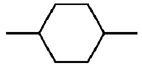 | | 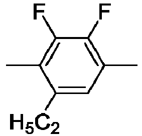 | O(CH₂)₄O(CH₂)₄ | - PO(OH)₂ |

Compounds of the formula IA-2, in which r = 1 and u = 0

| No. | T | Z^{T} | 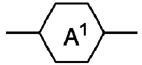 | Z¹ | 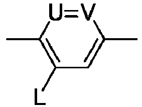 | Z³ | 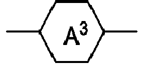 | G |
|---|---|---|---|---|---|---|---|---|
| | H | - | 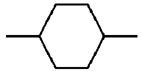 | | 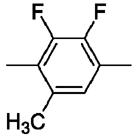 | O | 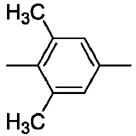 | - PO(OH)₂ |
| | CH₃ | - | 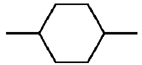 | | 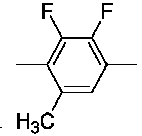 | O | 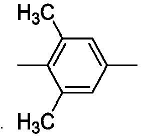 | PO(OH)₂ |
| | C₂H₅ | - | 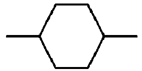 | | 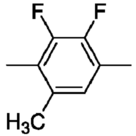 | O | 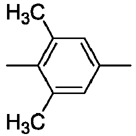 | PO(OH)₂ |
| | C₃H₇ | - | 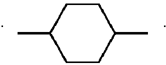 | | 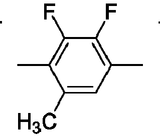 | O | 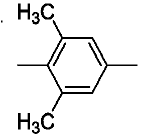 | PO(OH)₂ |
| | C₄H₉ | - | 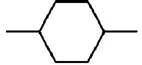 | | 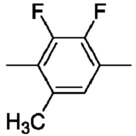 | O | 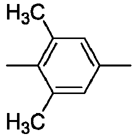 | PO(OH)₂ |
| | C₅H₁₁ | - | 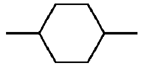 | | 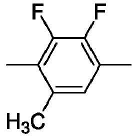 | O | 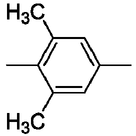 | PO(OH)₂ |
| | CH₂=CH | - | 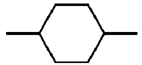 | | 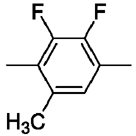 | O | 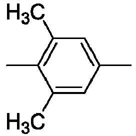 | PO(OH)₂ |
| | 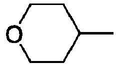 | - | 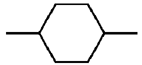 | | 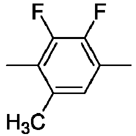 | O | 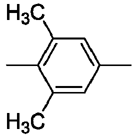 | - PO(OH)₂ |
| | 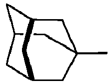 | CH₂O | 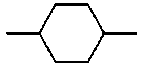 | | 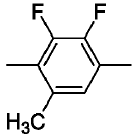 | O | 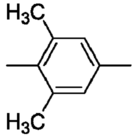 | - PO(OH)₂ |
| | H | - | 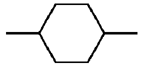 | | 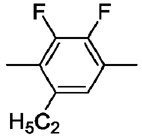 | O | 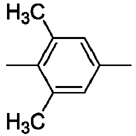 | - PO(OH)₂ |
| | CH₃ | - | 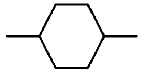 | | 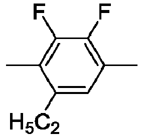 | O | 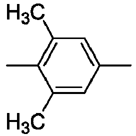 | PO(OH)₂ |
| | C₂H₅ | - | 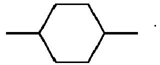 | | 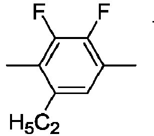 | O | 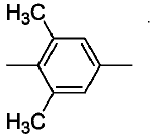 | PO(OH)₂ |
| | C₃H₇ | - | 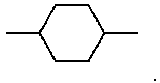 | | 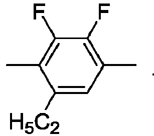 | O | 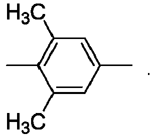 | PO(OH)₂ |
| | C₄H₉ | - | 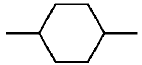 | | 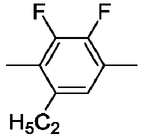 | O | 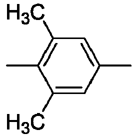 | PO(OH)₂ |
| | C₅H₁₁ | - | 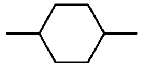 | | 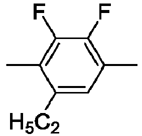 | O | 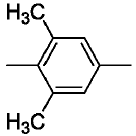 | PO(OH)₂ |
| | CH₂=CH | - | 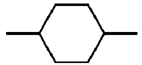 | | 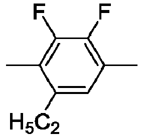 | O | 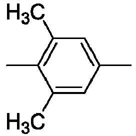 | - PO(OH)₂ |
| | 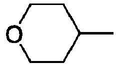 | - | 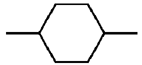 | | 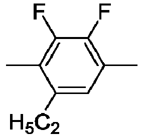 | O | 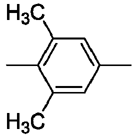 | - PO(OH)₂ |
| | 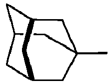 | CH₂O | 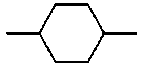 | | 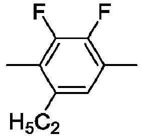 | O | 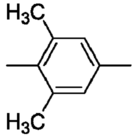 | - PO(OH)₂ |

### Device Fabrication

Test chips are prepared using compound A of synthesis example 1 and compound B known from prior art, respectively:

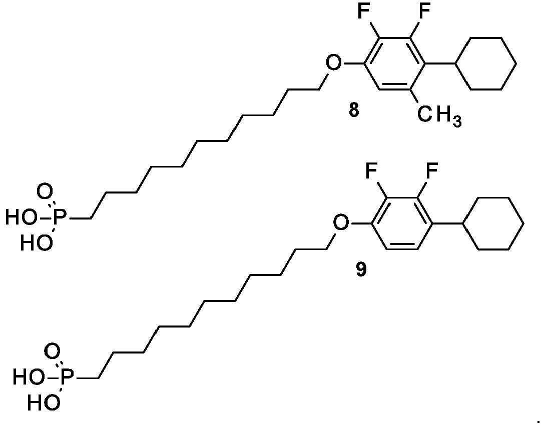

### Preparation of Test Chips:

A 45x45 mm silicon wafer with a 4 nm TiO top layer deposited by ALD is treated with ozone for 15 min and then immersed into a 1mM solution of compound A or B in THF for 72 h. The chip is dried in a stream of nitrogen and then tempered at 120°C for 1 h.

The chip is washed with THF and dried in a stream of nitrogen gas.

### Water contact angle measurements give the following results:

Compound A: 106.6°
Compound B: 104.8°.

### Electrical Characterization

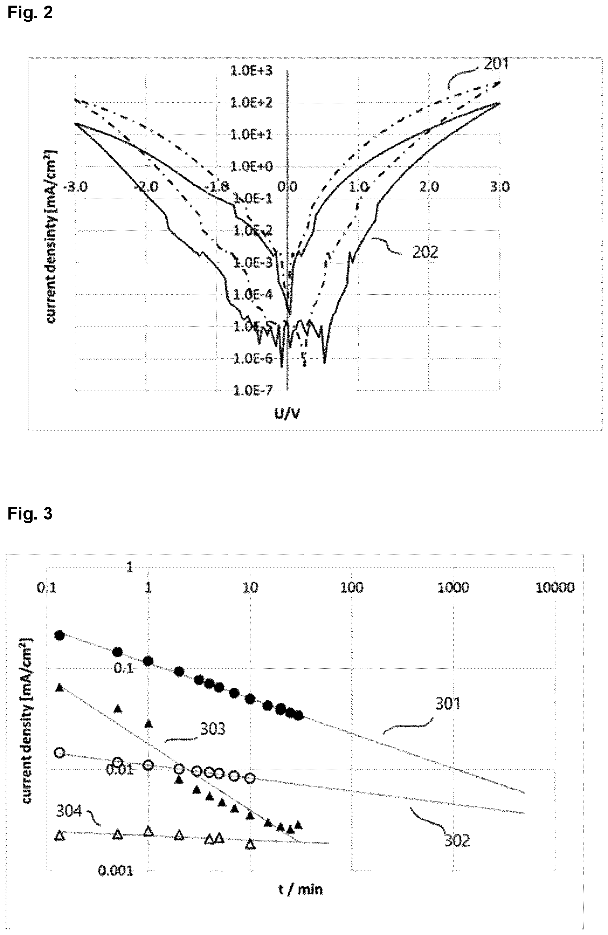

Two silicon wafers A and B obtained from treatment with compound A or B, respectively, are each glued with silver conductive paste to a copper plate that has been cleaned by dipping into 1M HCl. The silver conductive paste is annealed at 80°C for 10 min under a flow of nitrogen. The samples are then introduced into a nitrogen glovebox and contacted at the bottom on the copper contact and on the top by a Hg capillary. For each measurement a new fresh Hg drop is generated. The size of the drop is measured with a camera system for determination of the contact area. 4 cycles of current-voltage (I-V) measurements between -3 and +3 V in 40 mV steps are taken per contact area. For retention measurements a half cycle of the I-V measurement from 0 to 3V and back to 0 V for set operation (low resistive state, LRS) is performed. For Reset an I-V measurement from 0 to -3 V and back to 0 V is taken (high resistive state, HRS). After fixed time intervals a short constant voltage measurement at 1 V is done. The result for both wafers is shown in Fig. 2. Curve 201 shows the result for wafer A fabricated with compound A according to the invention. It shows a higher current density than the wafer B from the comparative compound (curve 202).

For both wafers A and B, the retention is determined at a voltage of 1V. Fig. 3 shows the change of the current density with time.

Line 301 shows the change of the current density with time for wafer A in the LRS. Line 302 shows the change of the current density with time for wafer A in the HRS. Line 303 shows the change of the current density with time for wafer B in the LRS. Line 304 shows the change of the current density with time for wafer B in the HRS.

The retention of a device is defined as the intersection of the respective HRS and LRS trend lines.

As a result, the retention of compound A is ca. 10000 min (approx. 1 week) which is improved by 3 orders of magnitude compared to the non-methylated reference compound B, which has a retention of 10-15 min.

## Claims

1. A compound of formula I 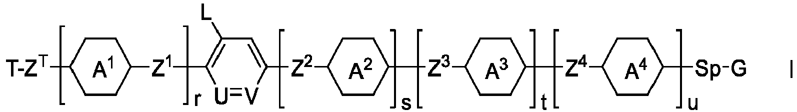 in which
U and V, identically or differently, denote C-F, C-CI, C-CF₃, C-CN or N,
L denotes straight chain or branched or cyclic alkyl or alkenyl each having 1 to 8 C atoms, where one or more non-adjacent CH₂ groups in these radicals may each be replaced, independently of one another, by -O- or -S-, and in which one or more H atoms may be replaced by F,
T is selected from the group of radicals consisting of the following groups:
a) straight chain or branched alkyl or alkoxy each having 1 to 20 C atoms, where one or more CH₂ groups in these radicals may each be replaced, independently of one another, by -C≡C- , -CH=CH-, 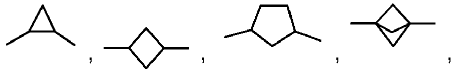 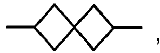 -O-, -S-, -CF₂O-, -OCF₂-, -CO-O-, -O-CO- ,-SiR⁰R⁰⁰- , -NH- , -NR⁰- or -SO₂- in such a way that O atoms are not linked directly to one another, and in which one or more H atoms may be replaced by halogen, CN, SCN or SF₅, wherein R⁰, R⁰⁰, identically or differently, denote an alkyl or alkoxy radical having 1 to 15 C atoms, in which, in addition, one or more H atoms may be replaced by halogen,
b) a three- to ten-membered saturated or partially unsaturated aliphatic ring, in which at least one -CH₂- group is replaced with -O-, -S-, -S(O)-, -SO₂-, -NR^{x}- or -N(O)R^{x}-, or in which at least one -CH= group is replaced with -N=, where R^{x} denotes straight-chain or branched alkyl having 1 to 6 C atoms,
c) a diamondoid radical, preferably derived from a lower diamondoid, very preferably selected from the group consisting of adamantyl, diamantyl, and triamantyl, in which one or more H atoms can be replaced by F, in each case optionally fluorinated alkyl, alkenyl or alkoxy having up to 12 C atoms, in particular 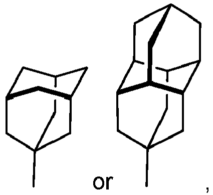
Z^{T}, Z¹, Z², and Z⁴, on each occurrence, identically or differently, denote a single bond, -CF₂O-, -OCF₂-, -CF₂S-, -SCF₂-, -CH₂O-, -OCH₂-, -C(O)O-, -OC(O)-, -C(O)S-, -SC(O)-, -(CH₂)ₙ₁-, -(CF₂)ₙ₂-, -CF₂ CH₂-, -CH₂CF₂-, -CH=CH-,-CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- or -N=C-C=N-, wherein n1, n2, n3, n4, identically or differently, are 1, 2, 3, 4, 5, 6, 7, 8, 9 or 10,
Z³ denotes -O-, -S-, -CH₂-, -C(O)-, -CF₂-, -CHF-, -C(R^{x})₂-, -S(O)- or -SO₂-, 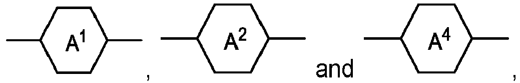 on each occurrence, identically or differently, denote an aromatic, heteroaromatic, alicyclic or heteroaliphatic ring having 4 to 25 ring atoms, which may also contain condensed rings and which may be mono- or polysubstituted by Y, 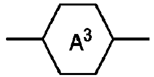 denotes an aromatic or heteroaromatic ring having 5 to 25 ring atoms, which may also contain condensed rings and which may be mono- or polysubstituted by Y^{C},
Y on each occurrence, identically or differently, denotes F, Cl, CN, SCN, SF₅ or straight-chain or branched, in each case optionally fluorinated alkyl, alkoxy, alkylcarbonyl, alkoxycarbonyl, alkylcarbonyloxy or alkoxycarbonyloxy having 1 to 12 C atoms, preferably F or Cl,
Y^{C} has one of the meanings of Y or denotes cycloalkyl or alkylcycloalkyl each having 3 to 12 C atoms, preferably methyl, ethyl, isopropyl, cyclopropyl, cyclobutyl, cyclopentyl, cyclohexyl, trifluoromethyl, methoxy or trifluoromethoxy,
Sp denotes a spacer group or a single bond,
R⁰, R⁰⁰, R^{x} denotes straight-chain or branched alkyl having 1 to 6 C atoms,
G denotes -OH, -SH, -SO₂OH, -OP(O)(OH)₂, -PO(OH)₂, -C(OH)(PO(OH)₂)₂, -COOH, -Si(OR^{x})₃, -SiCl₃, -CH=CH₂, -POCl₂, -COH(PO(OH)₂)₂, -CO(NHOH),-CO(NR⁰OH), -Si(NMe₂)₃; or straight chain or branched alkyl having 1 to 12 C atoms in which one, two or three not geminal H atoms are substituted by OH; or a group selected from -O-C(O)-OR^{V}, -O-C(O)-Si(OR^{x})₃, PO(OR^{V})₂, SO₂OR^{V},
R^{V} denotes straight chain or branched alkyl having 1 to 12 C atoms, and
r, s, t and u, identically or differently, are 0, 1 or 2.

2. The compound according to claim 1, wherein the compound is selected from the group consisting of the formulae IA-1a to IA-1f 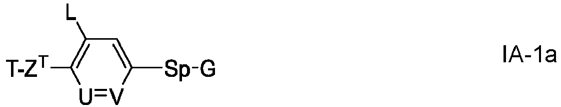 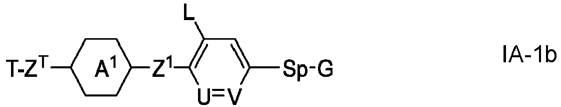 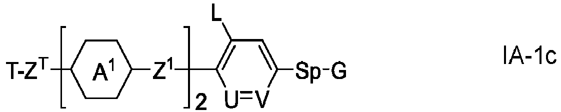 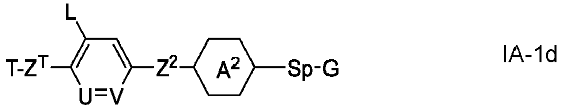 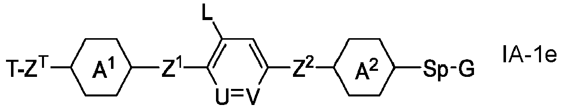 in which T, Z^{T}, 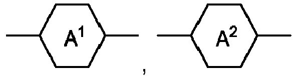 Z¹, Z², U, V, L, Sp and G have the meanings given in claim 1.

3. The compound according to claim 1 or 2, wherein
T denotes H, 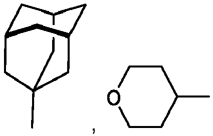 or straight chain or branched alkyl or alkoxy each having 1 to 7 C atoms or straight chain or branched alkenyl having 2 to 7 C atoms,
Z^{T} denotes CH₂O, OCH₂, CH₂CH₂, or a single bond,
Z¹ and Z² identically or differently, denote CH₂O, OCH₂, CH₂CH₂, CF₂O, OCF₂, C(O)O, OC(O) or a single bond,
A¹ and A², identically or differently, denote 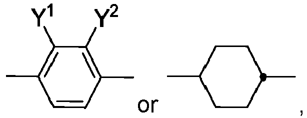
Y¹ and Y², identically or differently, denote F of Cl,
Sp denotes branched or unbranched 1,ω-alkylene having 1 to 12 C atoms, in which one or more non-adjacent CH₂-groups may be replaced by O,
G denotes -OP(O)(OH)₂, -PO(OH)₂, -COH(PO(OH)₂)₂ or -PO(OR^{V})₂,
R^{V} denotes methyl, ethyl or secundary or tertiary alkyl having 1 to 6 C atoms and
U, V and L have the meanings given in claim 1.

4. The compounds according to one or more of claims 1 to 3, wherein the compound is selected from the compounds of the formula IA-2 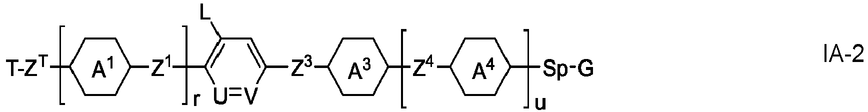 in which the occurring groups and parameters have the meanings given in claim 1.

5. The compound of formula IA-2 according to claim 4, wherein
A¹ and A⁴, identically or differently, denote
A³-Z³ denotes 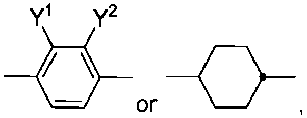 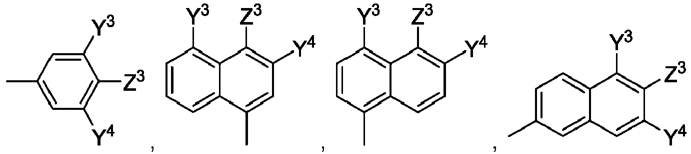 or 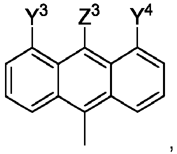
Z^{T} denote a single bond, -CH₂O-, -OCH₂- or -CH₂CH₂-,
Y¹ and Y² identically or differently, have one of the meanings given above for Y and preferably denote H, F or Cl,
Y³ and Y⁴, identically or differently, have one of the meanings given above for Y¹ and Y² and preferably denote methyl, ethyl, isopropyl, cyclopropyl, cyclobutyl, cyclopentyl, cyclopentenyl, cyclohexyl, cyclohexenyl, methoxy, trifluoromethyl, trifluoromethoxy, or trifluoromethylthio,
Z³ denotes CH₂ or O,
Z¹, Z², independently of one another, denote a single bond, -C(O)O-, -OC(O)-, -CF₂O-, -OCF₂-, -CH₂O-, OCH₂- or -CH₂CH₂-,
G denotes -OP(O)(OH)₂, -PO(OH)₂, -COH(PO(OH)₂)₂ or -PO(OR^{V})₂,
R^{V} denotes methyl, ethyl or secundary or tertiary alkyl having 1 to 6 C atoms,
r and u independently are 0, 1 or 2,
and L, U and V have the meanings given in claim 1.

6. The compound according to one or more of claims 1 to 5, wherein the radical L denotes Me, Et, n-Pr, iPr, CF₃, OCH₃, OCF₃, SCH₃, SCF₃, cyclopropyl, cyclobutyl, cyclopentyl, or cyclohexyl.

7. The compound according to one or more of claims 1 to 6, wherein U and V denote C-F or C-CI.

8. An Electronic switching device (100) which comprises, in this sequence,
a first electrode (102),
a molecular layer (103) bonded to the first electrode, and
a second electrode (104),
where the molecular layer is essentially formed from one or more compounds of formula I according to one or more of claims 1 to 7.

9. Electronic switching device (100) according to claim 8, wherein an interlayer (105) is arranged between the first electrode (102) and the molecular layer (103), where the interlayer (105) comprises an oxidic material and where the molecular layer (103) is bonded to said oxidic material, and where the first electrode (102) and the interlayer (105) are operable as a first electrode (102').

10. Electronic switching device (100) according to claim 9, wherein the oxidic interlayer comprises TiO₂, Al₂O₃, ZrO₂, HfO₂, or SiO₂.

11. Electronic switching device (100) according to one or more of claims 8 to 10, wherein the group G of the compounds of the formula I, as defined in claim 1, is bonded to the first electrode (102) by chemisorption or covalently.

12. Electronic switching device (100) according to one or more of claims 8 to 11, wherein the molecular layer (103) is a molecular monolayer.

13. Electronic component comprising one or more switching devices (100) according to one or more of claims 8 to 12.

14. Electronic component according to claim 13, wherein the component has a multitude of switching devices (100), where the first electrodes (102) and second electrodes (104) of the switching devices (100) form a crossbar array.

15. Electronic component according to claim 13 or 14, wherein the switching devices (100) are configured to change between a state having high electrical resistance and a state having low electrical resistance, where the quotient between high electrical resistance and low electrical resistance is between 10 and 100,000.

16. Electronic component according to claim 13, wherein the component is a resistive memory device, a sensor, a field-effect transistor or a Josephson junction.

17. Method for operating an electronic component according to one or more of claims 13 to 16, **characterised in that** a switching device (100) of the electronic component is switched into a state of high electrical resistance by setting a corresponding first electrode (102) to a first electrical potential and setting a corresponding second electrode (104) to a second electrical potential, where the value of the voltage between the two electrodes (102, 104) is greater than a first switching voltage and the first potential is greater than the second potential, a switching device (100) of the electronic component is switched into a state of low electrical resistance by setting a corresponding first electrode (102) to a third electrical potential and setting a corresponding second electrode (104) to a fourth electrical potential, where the value of the voltage between the two electrodes (102,104) is greater than a second switching voltage and the fourth potential is greater than the third potential, and the state of a switching device is determined by applying a reading voltage whose value is smaller than the first and second switching voltages between corresponding electrodes (102,104) and measuring the current flow.
